(19) Europäisches Patentamt

European Patent Office

Office européen des brevets

(11) **EP 0 944 173 B1**

(12) **EUROPEAN PATENT SPECIFICATION**

(45) Date of publication and mention
of the grant of the patent:
**21.01.2004 Bulletin 2004/04**

(51) Int Cl.⁷: **H03M 13/41**

(21) Application number: **99302042.9**

(22) Date of filing: **17.03.1999**

(54) **Add-compare selection circuit for a Viterbi decoder**

Addier- Vergleichs- Auswahl- Schaltung für einen Viterbi Dekodierer

Circuit d'addition-comparaison-sélection pour un décodeur de Viterbi

(84) Designated Contracting States:
**DE FR IT**

(30) Priority: **17.03.1998 GB 9805573**

(43) Date of publication of application:
**22.09.1999 Bulletin 1999/38**

(73) Proprietor: **SAMSUNG ELECTRONICS CO., LTD.**
**Suwon-City, Kyungki-do (KR)**

(72) Inventor: **Lee, Sang-Bong**
**Paldal-gu Suwon-shi Kyungki-do (KR)**

(74) Representative:
**Tunstall, Christopher Stephen et al**
**Harrison Goddard Foote,**
**Fountain Precinct,**
**Leopold Street**
**Sheffield S1 2QD (GB)**

(56) References cited:
**EP-A- 0 677 928**     **US-A- 5 251 233**

• **LOU H -L: "IMPLEMENTING THE VITERBI**
**ALGORITHM. FUNDAMENTALS AND**
**REAL-TIME ISSUES FOR PROCESSORS**
**DESIGNERS" IEEE SIGNAL PROCESSING**
**MAGAZINE,US,IEEE INC. NEW YORK, vol. 12,**
**no. 5, 1 September 1995 (1995-09-01), page 42-52**
**XP000651033 ISSN: 1053-5888**

**Description**

BACKGROUND OF THE INVENTION

The present invention relates to an apparatus and method for processing a Viterbi algorithm for example in a digital mobile communications system.

Viterbi algorithms can easily be used to implement a sequence determining method modelling a Gaussian channel. Conventionally, Viterbi algorithms are widely used owing to their excellent error correction rates. In Viterbi decoding, the distance of a received set of data to the data of all other possible paths on a trellis (each node of the trellis in a cycle "n" representing a state of the received set of data in that cycle) is determined and the possible path closest to the received path is selected. Once a surviving path has been decided upon, the corresponding sequence of bits, now decoded, can be traced back along this path. However, it does involve a lot of calculations and implementation time. In particular, the add-compare select (ACS) portion and trace-back portion require the greatest amount of time. If a constraint length "K" is applied in a convolutional encoder, the number of states, calculated by the ACS portion, is determined. Also, the path length of the trace-back portion, determined by simulation, plays an important role in determining the performance of a Viterbi algorithm.

In various mobile communication terminals which use TDMA, such as GSM, which is a European digital mobile communications standard, since the time for processing received data is predetermined, the Viterbi algorithm must be as fast as possible. For example, since a TDMA cycle of the GSM system is limited to 4.615 ns. It is most important to secure a time margin for the purpose of achieving stable operation.

Recently, baseband system have often been implemented by a DSP. However, since the Viterbi algorithm processing portion requires a lot of calculations and fast processing speed, a separate co-processing system is necessary. Although the Viterbi algorithm is determined in advance as described above, there is still the possibility of improvements in design which increase speed and efficiency.

EP 0 735 695, US 5 251 233 and Lou H-L; "Implementing the Viterbi Algorithm. Fundamentals and real-time issues for processor designers"; IEEE Signal Processing Magazine, Vol. 12, no. 5, page 42-52; 1 September 1995 disclose various implementations of Viterbi processing algorithms.

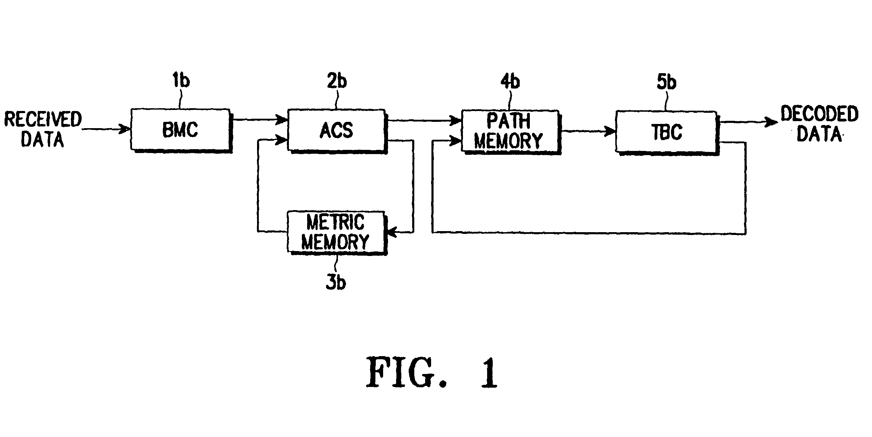

FIG. 1 is a block diagram of a conventional Viterbi decoder. A branch metric calculator (BMC) 1 receives a digital signal and calculates a branch metric value as probabilistic information. An add-compare selector (ACS) 2b inputs the branch metric value from the BMC 1 and updates a previous path metric corresponding to each state in a trellis, using the input branch metric value. The ACS 2b compares the updated path metrics with each other to determine the most likely one and outputs a selected path metric and a determining bit. In a metric memory 3b, the path metric selected by the ACS 2b is fed back to the ACS 2b in a subsequent step. A path memory 4b stores the determining bit output from the ACS 2b. A trace-back controller 5b implements a trace-back operation using the determining bit stored in the path memory 4b and traces back the sequence of original information.

The conventional design of the ACS 2b will now be described. For the sake of explanation, an example of 4 states will be used. It is necessary to trace the most likely metric in the Viterbi algorithm for searching proper data ie for determining the most likely correct data from the received data. The following formula is used for calculating a survival metric in the Viterbi algorithm over four states (00,01,10,11):

$$M_n, s0 = \max (M_{n-1}{}^{p0} + bmc1^{p0}{}_{s0} \cdot M_{n-1}{}^{p1} + bmc2^{p1}{}_{s0})$$

$$M_n, s1 = \max (M_{n-1}{}^{p2} + bmc1^{p2}{}_{s1} \cdot M_{n-1}{}^{p3} + bmc2^{p3}{}_{s1})$$

$$M_n, s2 = \max (M_{n-1}{}^{p0} + bmc1^{p0}{}_{s2} \cdot M_{n-1}{}^{p1} + bmc2^{p1}{}_{s2})$$

$$M_n, s3 = \max (M_{n-1}{}^{p2} + bmc1^{p2}{}_{s3} \cdot M_{n-1}{}^{p3} + bmc2^{p3}{}_{s3})$$

where M implies the survival metric of two metric values, $M_{n-1}{}^{p0}$ is an (n-1)th cycle survival metric for the 00 state, $M_{n-1}{}^{p1}$ is an (n-1) th cycle survival metric for the 01 state and so on; Mns0 is the selected survival metric for the nth cycle in the 00 state, Mnsl is the selected survival metric for the nth cycle in the 11 state, etc.; and bmc1$^{p0}{}_{s0}$ represents a first branch metric value (transition probability) to a state s0 (ie 00 in this case) from a state p0 (also 00 in this case) and bmc2$^{p1}{}_{s0}$ represents a second branch metric value to a state s0 but from a p1 (ie 11 state in this case).

The BMC 1b generates the same metric value as that of the convolutional encoder and obtains the difference from received data. Thus, the survival metric of the present state is the larger value of two values, i.e., a previous metric value and a value obtained by adding the previous metric value and the survival metric of the present state. To this end, at least two adders and a comparator are necessary.

To calculate the metric value of the present state, the previous metric value stored in the metric memory 3b is read and compared with a value obtained by adding the read metric value and the present metric value. Then the most similar value to the transmitted value is searched.

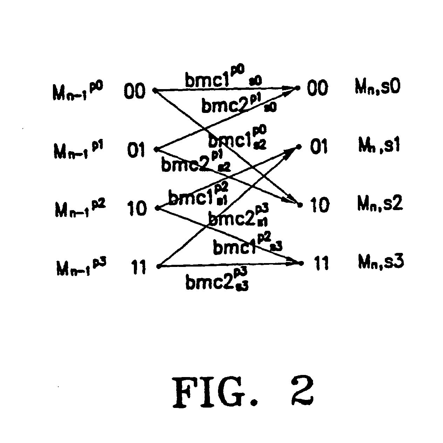

FIG. 2 illustrates metric values of the respective states and calculated branch metric values for calculating the survival metric of the Viterbi algorithm. As shown, to calculate the metric value of a state 00, the previous metric value $M_{n-1}p^0$ is read. Then, a value obtained by adding the same to $bmc1p^0{}_{s0}$ is compared with a value obtained by adding $M_{n-1}p^1$ to $bmc2p^1{}_{s0}$. Of the two values, the larger value is determined as the survival metric ($M_n$, s0) of the state 00. Thus, to obtain one survival metric value, 2 cycles are required in each state just for reading the previous metric values. In other words, to calculate the survival metric value, the previous metric values 0 and 1 must be read in the state 00, and the previous metric values 2 and 3 must be read in the state 01. When repeating such operation, 8 cycles are required only for reading the previous metric values to calculate the survival metric values in the case of four states.

However, according to this method, since the memory must frequently be accessed, high power consumption occurs. Also, since many clocks are used, this method is not suitable for high speed Viterbi algorithm implementation, such as GSM.

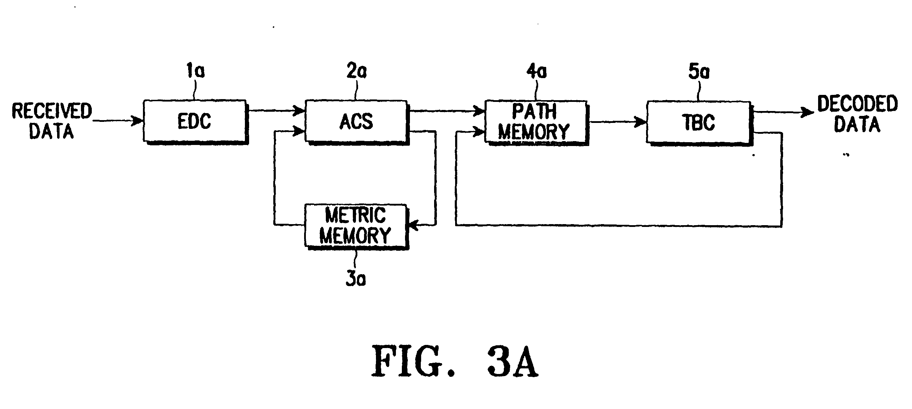

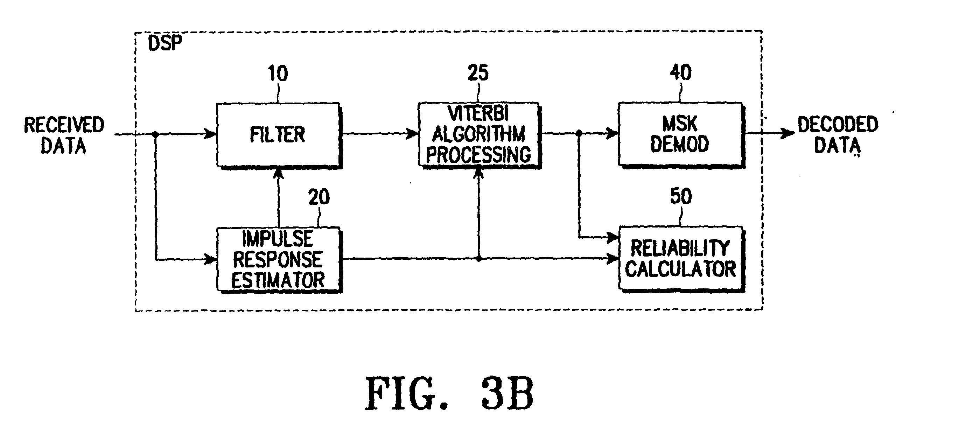

In the meantime, such a Viterbi algorithm processing apparatus is used for both a Viterbi equalizer and a Viterbi decoder. FIG. 3A illustrates a block diagram of a Viterbi algorithm processing apparatus included in the Viterbi equalizer, and FIG. 3B illustrates a block diagram of the Viterbi equalizer including the Viterbi algorithm processing apparatus.

Referring to FIG. 3B, an impulse response estimator 20 receives input data and measures a channel impulse response of the received data. A filter 10 is implemented by a finite impulse response (FIR) Filter designed to have the maximum signal-to-noise ratio at the output terminal at a particular time. The filter 10 is a matched filter which multiplies a reversal of the channel impulse response input from the impulse response estimator 20 by the received data and then time-shifts the multiplied value. A Viterbi algorithm processing apparatus 25 receives the data output from the filter 10 and the channel impulse response from the impulse response estimator 10 and performs the Viterbi algorithm for equalization. A demodulator 40 MSK demodulates data output from the Viterbi algorithm processing apparatus 25. A reliability calculator 50 calculates a reliability of the data processed in the Viterbi algorithm processing apparatus 25.

Such a Viterbi equalizer can be implemented by a DSP (Digital Signal Processor) or by hardware (eg, an equalizer processor or a VLSI). However, when realized by the DSP, the Viterbi equalizer has the increased calculations for Euclidean distance of the Viterbi algorithm, and the increased bit operations at the ACS and trace-back portions, causing numerous manipulations and increasing the power consumption. In addition, to satisfy the system timing, some DSP makers provide coprocessors. When realized by hardware, multipliers, dividers and adders are required according to the characteristics of the filter or the Viterbi algorithm, raising a complexity problem. Also, when the Viterbi equalizer is implemented by an ASIC (Application Specific Integrated Circuit), there may be raised a chip size problem.

Summary of the Invention

An objective of the present invention is to provide an apparatus and method for processing a Viterbi algorithm in a Viterbi decoder, which increases the processing speed of an ACS portion requiring a large quantity of calculation, thus reducing power consumption.

Another objective of the present invention is to provide a small high-speed Viterbi algorithm processing apparatus by divisionally designing the Viterbi algorithm into a portion to be processed by a digital signal processor and another portion to be processed by hardware according to the contents of the algorithm so as to increase the efficiency.

Accordingly the invention provides a high-speed add-compare selection apparatus, for a Viterbi algorithm processing apparatus having a branch metric calculator and a metric memory, comprising:

first and second registers;
the apparatus being characterised by
means for supplying to the second register a first previous metric value from the metric memory
means for supplying to the first register the first previous metric value from the second register and means for supplying to the second register a second previous metric value from the metric memory;
a first adder for adding the first previous metric value from the first register and a branch metric value of a present state of a common trellis stage calculated by the branch metric calculator;
a second adder for adding the second previous metric value from the second register and a branch metric value of a next state of the common trellis stage calculated by the branch metric calculator; and

a comparator for comparing the outputs of the first and second adders and calculating a survival metric value accordingly.

Preferably, the first and second metric values are Hamming distances.

Preferably, the first and second metric values are Euclidean distances.

Preferably, the first adder is for adding the first previous metric value input from the first register to a Euclidean value of a next state calculated by the Euclidean value calculator and the second adder is for adding the second previous metric value input from the second register to the Euclidean value of the next state calculated by the Euclidean value calculator.

In a still further aspect of the invention there is provided a Viterbi algorithm processing method for use in a processing apparatus having a branch metric calculator and a metric memory, the method including an add-compare-select operation comprising the steps of:

supplying to a second register a first previous metric from the metric memory and supplying to a first register the first previous metric value from the second register and supplying to the second register a second previous metric value from the metric memory;

calculating a first survival metric value of a present state of a common trellis stage using the first and second previous metric values from the first and second registers, a branch metric value of the present state calculated by the calculator and a branch metric value of the next state of the common trellis stage calculated by the calculator.

A Viterbi algorithm processing method, further comprising the steps of calculating a second survival metric value of another present state using the first and second previous metric values from the first and second registers, a branch metric value of the present state calculated by the calculator and a branch metric value of the next state calculated by the calculator.

A Viterbi algorithm processing method, further comprising the steps of

supplying to the first and second registers third and fourth previous metric values from the metric memory; and

calculating a third survival metric value of another present state using the third and fourth previous metric values from the first and second registers, a branch metric value of the present state calculated by the calculator and a branch metric value of the next state calculated by the calculator.

In a further aspect of the invention there is provided a Viterbi algorithm processing method comprising:

calculating a fourth survival metric value of another present state using the third and fourth previous metric values from the first and second registers, a branch metric value of the present state calculated by the branch metric calculator and a branch metric value of the next state calculated by the calculator.

The survival metric values of the present states may be calculated by:

adding the previous metric value from the first register and a branch metric value of the present state calculated by the calculator to provide a first added value;

adding the previous metric value from the second register and a branch metric value of the next state calculated by the calculator to provide a second added value; and

comparing the first and second added values and calculating a survival metric value accordingly.

In a further aspect of the invention there is provided a Viterbi equaliser comprising:

a Viterbi pre-processing portion for estimating a channel impulse response from received data and for filtering the data using the impulse response using a digital signal processor; and

a Viterbi algorithm processing apparatus, comprising a high-speed add-compare selection apparatus as claimed in any of claims 1 to 4, for performing a Viterbi algorithm for equalisation of the filtered data using the estimated channel impulse response provided from the Viterbi pre-processing portion.

Preferably, the pre-processing portion multiplies a reversal of the estimated channel impedance response by the received data, and time-shifts the mulitplied result.

Preferably, a Viterbi equalizer comprises a high speed add-compare selection apparatus as described herein.

Brief Description of the Drawings

The present invention will now be described by way of example with reference to the accompanying drawings in which:

Fig. 1 is a block diagram of a conventional Viterbi decoder.

Fig. 2 illustrates metric values of each state and calculated branch metric values for calculating the survival metric of a Viterbi algorithm.

FIG. 3A is a block diagram of a Viterbi algorithm processing apparatus included in the Viterbi equalizer.

FIG. 3B is a block diagram of the Viterbi equalizer including the Viterbi algorithm processing apparatus of FIG. 3A.

FIG. 4 is a schematic diagram of an add-compare selector of a Viterbi decoder according to a preferred embodiment of the present invention.

FIG. 5 is an operational timing diagram according to a preferred embodiment of the present invention.

FIG. 6 is a diagram for explaining how to implement the Viterbi equalizer according to an embodiment of the present invention.

Detailed Description of the Preferred Embodiment

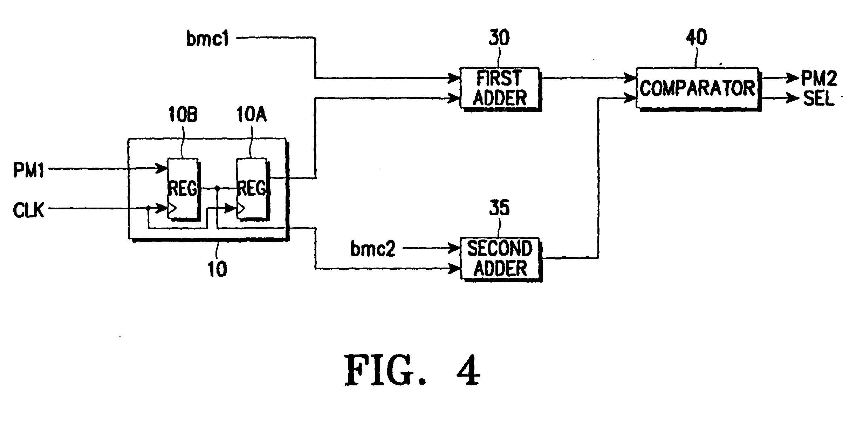

FIG. 4 is a schematic diagram of an add-compare selector of a Viterbi decoder according to a preferred embodiment of the present invention. In FIG. 4, by replacing bmc1 and bmc2 with edc1 and edc2, it is possible to implement the ACS of a Viterbi equalizer.

The add-compare selector of FIG. 4 includes a register portion 10 comprising a second register 10B for storing a predetermined previous metric value read from the metric memory 3b shown in FIG. 1 and a first register 10A for storing the previous metric value shifted and input from the second register 10B. A first adder 30 adds the first previous metric value input from the first register 10A to a calculated branch metric value bmc1 of the present state, output from the BMC shown in FIG. 1. A second adder 35 adds the second previous metric value input from the second register 10B to a calculated branch metric value bmc2 of the next state, also output from the BMC shown in FIG. 1. A comparator 40 compares the outputs of the first and second adders 30 and 35 to determine the larger value as the survival metric, i.e., the present metric value PM2.

The first and second branch metric values bmc1 and bmc2 may be Euclidian distances in an equalizer or Hamming distances in a convolutional decoder. The BMC 1b shown in FIG. 1, used in the present invention, obtains the difference between received data and predetermined transmitted data, which is the first and second branch metric values bmc1 and bmc2.

The previous metric value PM1 is read from the metric memory 3b. The number and length of the states may be changed according to use. Also, the size of the first and second registers 10A and 10B and the first and second adders 30 and 35 are determined accordingly.

As expressed in the above formula, in the case of a state 00, the previous metric value $M_{n-1}p0$ is read. Then, the value obtained by adding the read value with $bmc1p0_{s0}$ are compared with the value obtained by adding metric value $M_{n-1}p1$, in effect the probability of being in a state p1(01) in the (n-1)th cycle having followed a given path, and $bmc2p1_{s0}$, the probability of a transition to state s0(00) from state p1(01). Of the two values, the larger value is determined as the survival metric $M_n,s0$ of the state 00.

The information indicating which of the two survives, i.e., a determining bit, is generated by the comparator 40. The determining bit (SEL) is stored in the path memory 4b and is to be used later in tracing back data.

The gist of the present invention is in that the data, and in particular previous metric values, such as $M_{n-1}p0$, is read from a previous metric memory and stored in the register portion 10 to be used in calculating the next state, without the need to use the same memory repeatedly. Referring to FIG. 2, the metric values of the previous states 00 and 01 are read in both of the present states 00 and 10, respectively. Therefore, the sequence of calculating the present metric states is from 00 to 10 to 01 to 11, unlike the conventional sequence from 00 to 01 to 10 to 11. In other words, the sequence of reading the previous metric memory is from the state 00 to 01 (for present state 00) to 00 to 01 (for present state 10) to 10 to 11 (for present state 01) to 10 to 11 (for present state 11). Thus, the metric values corresponding to the previous states 00 and 01 read from the metric memory 3b are latched to the first and second registers 10B and 10A of the register portion 10 respectively and then the ACS values of the present states 00 and 10 are sequentially calculated. Thus, after calculating the present state 00, the metric values corresponding to the previous states 00 and 01 are read from the first and second registers 10B and 10A, thus calculating the ACS output value of the present state 10, without the need to read the metric memory 3b again.

The metric values of the previous states 10 and 11 are latched from the metric memory 3b and then stored in the first and second registers 10B and 10A. Then, the present states 01 and 11 are sequentially calculated in a similar manner to that described above. Thus, the number of times the previous metric values are read from the metric memory 3b is reduced from 8 times to 4 times.

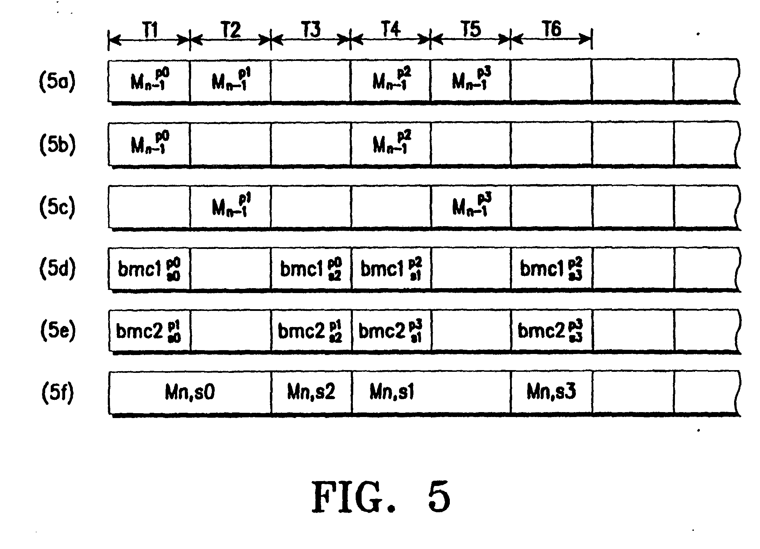

FIG. 5 is an operational timing diagram according to a preferred embodiment of the present invention, in which FIG. 5A illustrates the sequence of reading previous metric values from the metric memory 3b, FIG. 5B illustrates the value of the first register 10B in the register portion 10, FIG. 5C illustrates the value of the second register 10A, FIG. 5D illustrates the value of bmc1, FIG. 5E illustrates the value of bmc2 and FIG. 5F illustrates the present metric value stored in the path memory 4b.

As shown by periods T1 and T2 in FIG. 5A, the metric values $M_{n-1}^{p0}$ and $M_{n-1}^{p1}$ for the previous states 00 and 01 are sequentially read from the metric memory 3b. Then, as shown by block T1 in FIG. 5B and block T2 in FIG. 5C, the values read are stored in the first and second registers 10A and 10B respectively. As shown by block T1 in FIGs. 5D and 5E, using the values $bmc1^{p0}_{s0}$ and $bmc2^{p1}_{s0}$, calculated by the BMC 1b, the ACS values are calculated based on the above formula (1). The resulting present metric value of the present state 00 is $M_n$, s0, as shown by blocks T1 and T2 in FIG. 5F.

Next, the metric values $M_{n-1}^{p0}$ and $M_{n-1}^{p1}$ for the previous states 00 and 01, stored in the first and second registers 10B and 10A, and the values $bmc1^{p0}_{s2}$ and $bmc2^{p1}_{s2}$, calculated by the BMC 1b and shown by block T3 in FIGs. 5D and 5E, are used to calculate the ACS values based on the above formula (1). The resulting present metric value of the present state 10 is $M_n$, s2, as shown by block T3 in FIG. 5F.

As shown by blocks T4 and T5 in FIG. 4A, the metric values $M_{n-1}^{p2}$ and $M_{n-1}^{p3}$ for the previous states 10 and 11 are sequentially read from the metric memory 3b. Then, as shown by block T4 in FIG. 5B and block T5 in FIG. 5C, the values read are stored in the first and second registers 10A and 10B respectively. As shown by block T4 in FIGs. 5D and 5E, using the values $bmc1^{p0}_{s0}$ and $bmc2^{p1}_{s0}$, calculated by the BMC 1b, the ACS values are calculated based on the above formula (1). The resulting present metric value of the present state 01 is $M_n$, s1, as shown by blocks T4 and T5 in FIG. 5F.

Next, the metric values $M_{n-1}^{p2}$ and $M_{n-1}^{p3}$ for the previous states 10 and 11, stored in the first and second registers 10B and 10A, and the values $bmc1^{p2}_{s3}$ and $bmc2^{p3}_{s3}$, calculated by the BMC 1b and shown by block T6 in FIGs . 5D and 5E, the ACS values are calculated based on the above formula (1). The resulting present metric value of the present state 11 is $M_n,s3$, as shown by block T6 in FIG. 5F.

In conclusion, as described above, the sequence of calculating the present metric values is changed, i.e., 00 to 10 to 01 to 11. Thus, when obtaining the metric values of the present states 10 and 11, it is not necessary to access the memory again to read the previous metric values. Instead, the previous metric values read for obtaining the metric values of the present states 00 and 01 are used, thus saving time.

In other words, in the case of four states, the number of times the metric memory 3b is read is conventionally 8 times, but 4 times according to the present invention. Also, the number of overall required clocks is reduced by 2 clock cycles. Thus, 8 clock cycles are required conventionally, but only 6 clock cycles are required according to the present invention. The blocks T1 through T6 correspond to unit clock cycles.

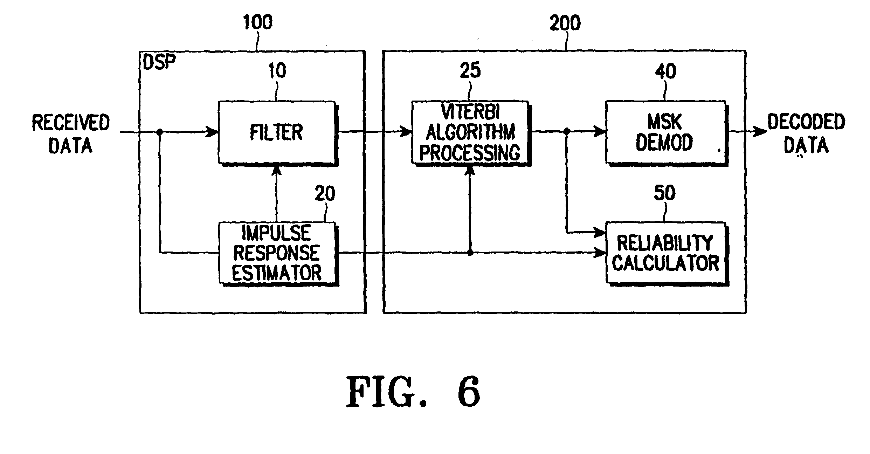

FIG. 6 illustrates an exemplary Viterbi equalizer according to an embodiment of the present invention. The filter 10 and the impulse response estimater 20 represented by a block 100 is a preprocessing portion and is implemented by the DSP. A portion represented by reference numeral 200 is a pure Viterbi algorithm processing portion and is implemented by hardware.

In FIG. 6, the Viterbi algorithm processing apparatus 25 has the same structure as that shown in FIG. 3B. An EDC (Euclidian Distance Calculation) 1a in FIG. 3A implements the known calculations given by

$$edc^{p0}_{sk(k=0.2)} = \left| r_n - r^{p0}_{sk} \right|^2 [R(r_n)-R(r^{p0}_{sk})]^2 + [I(r_n)-I(r^{p0}_{sk})]$$

$$edc^{p2}_{sk(k=1,3)} = \left| r_n - r^{p2}_{sk} \right|^2 = [R(r_n)-R(r^{p2}_{sk})]^2 + [I(r_n)-I(r^{p2}_{sk})]$$

$$edc^{p1}_{sk(k=0,2)} = \left| r_n - r^{p1}_{sk} \right|^2 = [R(r_n) - R(r^{p1}_{sk})]^2 + (I(r_n) - I(r^{p1}_{sk})]$$

$$edc^{p3}_{sk(k=1,3)} = \left| r_n - r^{p3}_{sk} \right|^2 = [R(r_n) - R(r^{p3}_{sk})]^2 + [I(r_n) - I(r^{p3}_{sk})]$$

where R is a real number, I is an imaginary number, $r_n$ is received data, and $r_n^{p1}$ and $r_n^{p2}$ are reference data.

To perform the Euclidian calculation, the EDC 1a requires subtracters, multipliers and adders. After Euclidian calculation, the ACS 2a performs the known add-compares calculation given by

$$M_n, s0 = \min(M_{n-1}^{p0} + edc1^{p0}{}_{s0}, M_{n-1}^{p1} + edc2^{p1}{}_{s0})$$

$$Mn, s1 = \min(M_{n-1}^{p2} + edc1^{p2}{}_{s1}, M_{n-1}^{p3} + edc2^{p1}{}_{s1})$$

$$M_n, s2 = \min(M_{n-1}^{p0} + edc1^{p0}{}_{s2}, M_{n-1}^{p1} + edc2^{p1}{}_{s2})$$

$$M_n, s3 = \min(M_{n-1}^{p2} + edc1^{p2}{}_{s3}, M_{n-1}^{p3} + edc2^{p1}{}_{s3})$$

The order in which these calculations can be carried out can be the same as described in connection with branch metric calculators. Indeed by replacing bmc1 and bmc2 with edc1 and edc2, the apparatus of fig. 4 can be used for this purpose.

For the add-compare calculation, the ACS 2a requires adders and comparators. Like the Euclidian calculation, the add-compare calculation also requires calculations (additions) twice in the respective states ie to calculate the $M_n s0$ and $M_n s2$ or $M_n s1$ and $M_n s3$. Therefore, it is possible to increase the data processing speed by implementing this portion ie ACS 2a by hardware to operate in parallel. In other words, the conventional apparatus implemented by the DSP performs the calculations in sequence, which takes more time, as compared with the case where the calculations are performed in parallel. In the embodiment, the portion for processing the pure Viterbi algorithm is implemented by hardware, so that about 1/5 cycle time is required as compared with the case where it is implemented by the DSP, thereby reducing the power consumption and securing the time margin in implementing the system.

As described above, according to the present invention, overall Viterbi processing time can be reduced (e.g. by 25% when using an ACS block as in the described embodiment of the present invention). In other words, instead of the conventional ACS calculating method, by changing the sequence of reading the memory, the overall number of memory accesses and memory access time can be reduced, which allows for a certain timing margin in implementing the system, thus increasing reliability. Also, power consumption can be reduced by reducing the number of times the memory is read.

Furthermore, by divisionally implementing the Viterbi equalizer and the Viterbi decoder into a portion to be processed by the DSP and a portion to be processed by the hardware, it is possible to consider the particulars pertinent to the size of the mobile communication terminal at the design state. In addition, the portion implemented by hardware has a parallel data processing path, increasing the data processing speed.

**Claims**

1.  A high-speed add-compare selection apparatus, for a Viterbi algorithm processing apparatus having a branch metric calculator and a metric memory, comprising:

    first and second registers;

    the apparatus being **characterised by**

    means for supplying to the second register a first previous metric value from the metric memory,

    means for supplying to the first register the first previous metric value from the second register and means for supplying to the second register a second previous metric value from the metric memory;

    a first adder for adding the first previous metric value from the first register and a branch metric value of a present state of a common trellis stage calculated by the branch metric calculator;

    a second adder for adding the second previous metric value from the second register and a branch metric value of a next state of the common trellis stage calculated by the branch metric calculator; and

    a comparator for comparing the outputs of the first and second adders and calculating a survival metric value accordingly.

2. A high-speed add-compare selection apparatus according to claim 1 in which the first and second metric values are Hamming distances.

3. A high-speed add-compare selection apparatus according to claim 1 in which the first and second metric values are Euclidian distances.

4. A high-speed add-compare selection apparatus according to any preceding claim in which the first adder is for adding the first previous metric value input from the first register to a Euclidean value of a next state calculated by the Euclidean value calculator and the second adder is for adding the second previous metric value input from the second register to the Euclidean value of the next state calculated by the Euclidean value calculator.

5. A Viterbi algorithm processing method for use in a processing apparatus having a branch metric calculator and a metric memory, the method including an add-compare-select operation comprising the steps of:

supplying to a second register a first previous metric from the metric memory, supplying to a first register the first previous metric value from the second register and supplying to the second register a second previous metric value from the metric memory;
calculating a first survival metric value of a present state of a common trellis stage using the first and second previous metric values from the first and second registers, a branch metric value of the present state calculated by the calculator and a branch metric value of the next state of the common trellis stage calculated by the calculator.

6. A Viterbi algorithm processing method as claimed in claim 5, further comprising the steps of
calculating a second survival metric value of another present state using the first and second previous metric values from the first and second registers, a branch metric value of the present state calculated by the calculator and a branch metric value of the next state calculated by the calculator.

7. A Viterbi algorithm processing method as claimed in claim 6, further comprising the steps of
supplying to the first and second registers third and fourth previous metric values from the metric memory; and
calculating a third survival metric value of another present state using the third and fourth previous metric values from the first and second registers, a branch metric value of the present state calculated by the calculator and a branch metric value of the next state calculated by the calculator.

8. A Viterbi algorithm processing method according to claim 7 further comprising:

calculating a fourth survival metric value of another present state using the third and fourth previous metric values from the first and second registers, a branch metric value of the present state calculated by the branch metric calculator and a branch metric of the next state calculated by the calculator.

9. A Viterbi algorithm processing method according to claims 5 to 8 in which the survival metric values of the present states are calculated by:

adding the previous metric value from the first register and a branch metric value of the present state calculated by the calculator to provide a first added value;

adding the previous metric value from the second register and a branch metric value of the next state calculated by the calculator to provide a second added value; and

comparing the first and second added values and calculating a survival metric value accordingly.

10. A Viterbi equaliser comprising:

a Viterbi pre-processing portion for estimating a channel impulse response from received data and for filtering the data using the impulse response using a digital signal processor; and

a Viterbi algorithm processing apparatus, comprising a high-speed add-compare selection apparatus as claimed in any of claims 1 to 4, for performing a Viterbi algorithm for equalisation of the filtered data using the estimated channel impulse response provided from the Viterbi pre-processing portion.

**11.** An equalizer according to claim 10 in which the pre-processing portion multiplies a reversal of the estimated channel impedance response by the received data, and time-shifts and multiplied result.

**Patentansprüche**

**1.** Hochgeschwindigkeits-Addier-/Vergleichs-/Auswahl-Vorrichtung für eine Viterbi-Algorithmus-Verarbeitungsvorrichtung mit einer verzweigten metrischen Rechenmaschine und einem metrischen Speicher, mit:

einem ersten und zweiten Register;

wobei die Vorrichtung **gekennzeichnet ist durch** Einrichtungen, um einen ersten vorhergehenden metrischen Wert aus dem metrischen Speicher zu dem zweiten Register zu liefern, Einrichtungen, um den ersten vorhergehenden metrischen Wert aus dem zweiten Register zu dem ersten Register zu liefern, und Einrichtungen, um einen zweiten vorhergehenden metrischen Wert aus dem metrischen Speicher zu dem zweiten Register zu liefern;

einem ersten Addierer, um den ersten vorhergehenden metrischen Wert aus dem ersten Register und einen verzweigten metrischen Wert von einer aktuellen Stufe von einer gemeinsamen Trellis-Stufe zu addieren, der **durch** die verzweigte metrische Rechenmaschine berechnet ist;

einem zweiten Addierer, um den zweiten vorhergehenden metrischen Wert aus dem zweiten Register und einen verzweigten metrischen Wert von einer nächsten Stufe von der gemeinsamen Trellis-Stufe zu addieren, der **durch** die verzweigte metrische Rechenmaschine berechnet ist; und

einem Vergleicher, um die Ausgänge von dem ersten und dem zweiten Addierer zu vergleichen und um entsprechend einen metrischen Überlebens-Wert zu berechnen.

**2.** Hochgeschwindigkeits-Addier-/Vergleichs-/Auswahl-Vorrichtung nach Anspruch 1, bei der der erste und der zweite metrische Wert Hamming-Distanzen sind.

**3.** Hochgeschwindigkeits-Addier-/Vergleichs-/Auswahl-Vorrichtung nach Anspruch 1, bei der der erste und der zweite metrische Wert euklidische Distanzen sind.

**4.** Hochgeschwindigkeits-Addier-/Vergleichs-/Auswahl-Vorrichtung nach einem der vorhergehenden Ansprüche, bei der der erste Addierer dazu ausgestaltet ist, um den ersten vorhergehenden metrischen Wert, der aus dem ersten Register eingegeben ist, zu einem euklidischen Wert von einer nächsten Stufe zu addieren, der durch die Rechenmaschine für den euklidischen Wert berechnet ist, und der zweite Addierer dazu ausgestaltet ist, um den zweiten vorhergehenden metrischen Wert, der aus dem zweiten Register eingegeben ist, zu dem euklidischen Wert von der nächsten Stufe zu addieren, der durch die Rechenmaschine für den euklidischen Wert berechnet ist.

**5.** Viterbi-Algorithmus-Verarbeitungsverfahren zur Verwendung in einer Verarbeitungsvorrichtung mit einer verzweigten metrischen Rechenmaschine und einem metrischen Speicher, wobei das Verfahren, das eine Addier-/Vergleichs-/Auswahl-Operation beinhaltet, die Schritten umfasst:

Liefern von einem ersten vorhergehenden metrischen Wert aus dem metrischen Speicher zu einem zweiten Register,

Liefern von dem ersten vorhergehenden metrischen Wert aus dem zweiten Register zu einem ersten Register, und Liefern von einem zweiten vorhergehenden metrischen Wert aus dem metrischen Speicher zu dem zweiten Register;

Berechnen von einem ersten metrischen Überlebens-Wert von einer aktuellen Stufe von einer gemeinsamen Trellis-Stufe unter Verwendung von dem ersten und zweiten vorhergehenden metrischen Wert aus dem ersten und zweiten Register, von einem verzweigten metrischen Wert von der aktuellen Stufe, der durch die Rechenmaschine berechnet ist, und von einem verzweigten metrischen Wert von der nächsten Stufe von der gemeinsamen Trellis-Stufe, der durch die Rechenmaschine berechnet ist.

**6.** Viterbi-Algorithmus-Verarbeitungsverfahren nach Anspruch 5, außerdem mit den Schritten:

Berechnen von einem zweiten metrischen Überlebens-Wert von einer anderen aktuellen Stufe unter Verwendung von dem ersten und zweiten vorhergehenden metrischen Wert aus dem ersten und zweiten Register, von einem verzweigten metrischen Wert von der aktuellen Stufe, der durch die Rechenmaschine berechnet ist, und von einem verzweigten metrischen Wert von der nächsten Stufe, der durch die Rechenmaschine berechnet ist.

**7.** Viterbi-Algorithmus-Verarbeitungsverfahren nach Anspruch 6, außerdem mit den Schritten:

Liefern von einem dritten und vierten vorhergehenden metrischen Wert aus dem metrischen Speicher zu dem ersten und zweiten Register; und
Berechnen von einem dritten metrischen Überlebens-Wert von einer anderen aktuellen Stufe unter Verwendung von dem dritten und vierten vorhergehenden metrischen Wert aus dem ersten und zweiten Register, von einem verzweigten metrischen Wert von der aktuellen Stufe, der durch die Rechenmaschine berechnet ist, und von einem verzweigten metrischen Wert von der nächsten Stufe, der durch die Rechenmaschine berechnet ist.

**8.** Viterbi-Algorithmus-Verarbeitungsverfahren nach Anspruch 7, außerdem mit:

Berechnen von einem vierten metrischen Überlebens-Wert von einer anderen aktuellen Stufe unter Verwendung von dem dritten und vierten vorhergehenden metrischen Wert aus dem ersten und zweiten Register, von einem verzweigten metrischen Wert von der aktuellen Stufe, der durch die verzweigte metrische Rechenmaschine berechnet ist, und von einem verzweigten metrischen Wert von der nächsten Stufe, der durch Rechenmaschine berechnet ist.

**9.** Viterbi-Algorithmus-Verarbeitungsverfahren nach einem der Ansprüche 5 bis 8, bei dem die metrischen Überlebens-Werte von den aktuellen Stufen berechnet werden durch:

Addieren von dem vorhergehenden metrischen Wert aus dem ersten Register und von einem verzweigten metrischen Wert von der aktuellen Stufe, der durch die Rechenmaschine berechnet ist, um einen ersten addierten Wert bereitzustellen;
Addieren von dem vorhergehenden metrischen Wert aus dem zweiten Register und von einem verzweigten metrischen Wert von der nächsten Stufe, der durch die Rechenmaschine berechnet ist, um einen zweiten addierten Wert bereitzustellen; und
Vergleichen von dem ersten und zweiten addierten Wert und entsprechendes Berechnen von einem metrischen Überlebens-Wert.

**10.** Viterbi-Entzerrer, mit:

einem Viterbi-Vorverarbeitungsbereich zum Schätzen einer Kanalimpulsantwort aus empfangenen Daten und zum Filtern der Daten unter Verwendung der Impulsantwort unter Verwendung eines digitalen Signalprozessors; und
einer Viterbi-Algorithmus-Verarbeitungsvorrichtungmit einer Hochgeschwindigkeits-Addier-/Vergleichs-/Auswahl-Vorrichtung nach einem der Ansprüche 1 bis 4, um einen Viterbi-Algorithmus zum Entzerren der gefilterten Daten durchzuführen, und zwar unter Verwendung der geschätzten Kanalimpulsantwort, die von dem Viterbi-Vorverarbeitungsbereich bereitgestellt wird.

**11.** Entzerrer nach Anspruch 10, wobei der Vorverarbeitungsbereich eine Umkehrung der geschätzten Kanalimpedanzantwort mit den empfangenen Daten multipliziert und das multiplizierte Ergebnis zeitlich verschiebt.

**Revendications**

**1.** Appareil d'addition-comparaison-sélection haute vitesse, pour un appareil de traitement par algorithme de Viterbi ayant un calculateur métrique de branche et une mémoire métrique, comprenant :

- des premier et second registres ;

l'appareil étant **caractérisé par** :

- un moyen pour adresser au second registre une première valeur métrique précédente provenant de la mémoire métrique, un moyen pour adresser au premier registre la première valeur métrique précédente provenant du second registre, et un moyen pour adresser au second registre une seconde valeur métrique précédente provenant de la mémoire métrique ;

- un premier additionneur pour ajouter la première valeur métrique précédente provenant du premier registre et une valeur métrique de branche d'un état présent d'un étage de treillis commun calculée par le calculateur métrique de branche ;
- un second additionneur pour ajouter la seconde valeur métrique précédente provenant du second registre et une valeur métrique de branche d'un état suivant de l'étage de treillis commun calculée par le calculateur métrique de branche ; et
- un comparateur pour comparer les sorties des premier et second additionneurs et calculer en conséquence une valeur métrique de survie.

2. Appareil d'addition-comparaison-sélection haute vitesse, selon la revendication 1, dans lequel les première et seconde valeurs métriques sont des distances de Hamming.

3. Appareil d'addition-comparaison-sélection haute vitesse, selon la revendication 1, dans lequel les première et seconde valeurs métriques sont des distances euclidiennes.

4. Appareil d'addition-comparaison-sélection haute vitesse, selon l'une quelconque des revendications précédentes, dans lequel le premier additionneur est destiné à ajouter la première entrée de valeur métrique précédente provenant du premier registre à une valeur euclidienne d'un état suivant calculée par le calculateur de valeurs euclidiennes, et le second additionneur est destiné à ajouter la seconde entrée de valeur métrique précédente provenant du second registre à la valeur euclidienne de l'état suivant calculée par le calculateur de valeurs euclidiennes.

5. Procédé de traitement par algorithme de Viterbi, destiné à être utilisé dans un appareil de traitement ayant un calculateur métrique de branche et une mémoire métrique, le procédé comprenant une opération d'addition-comparaison-sélection comprenant les étapes consistant à :

- adresser à un second registre une première valeur métrique précédente provenant de la mémoire métrique, adresser à un premier registre la première valeur métrique préalable provenant du second registre et adresser au second registre une seconde valeur métrique préalable provenant de la mémoire métrique ;
- calculer une première valeur métrique de survie d'un état présent d'un étage de treillis commun à l'aide des première et seconde valeurs métriques précédentes provenant des premier et second registres, une valeur métrique de branche de l'état présent calculée par le calculateur et une valeur métrique de branche de l'état suivant de l'étage de treillis commun calculée par le calculateur.

6. Procédé de traitement par algorithme de Viterbi selon la revendication 5, comprenant en outre les étapes consistant à :

- calculer une seconde valeur métrique de survie d'un autre état présent à l'aide des première et seconde valeurs métriques précédentes provenant des premier et second registres, une valeur métrique de branche de l'état présent calculée par le calculateur et une valeur métrique de branche de l'état suivant calculée par le calculateur.

7. Procédé de traitement par algorithme de Viterbi, selon la revendication 6, comprenant en outre les étapes consistant à :

- adresser aux premier et second registres des troisième et quatrième valeurs métriques précédentes provenant de la mémoire métrique ; et
- calculer une troisième valeur métrique de survie d'un autre état présent à l'aide des troisième et quatrième valeurs métriques précédentes provenant des premier et second registres, une valeur métrique de branche de l'état présent calculée par le calculateur et une valeur métrique de branche de l'état suivant calculée par le calculateur.

8. Procédé de traitement par algorithme de Viterbi, selon la revendication 7, comprenant en outre l'étape consistant à :

- calculer une quatrième valeur métrique de survie d'un autre état présent à l'aide des troisième et quatrième valeurs métriques précédentes provenant des premier et second registres, une valeur métrique de branche de l'état présent calculée par le calculateur métrique de branche et une valeur métrique de branche de l'état suivant calculée par le calculateur.

9. Procédé de traitement par algorithme de Viterbi, selon l'une des revendications 5 à 8, dans lequel les valeurs métriques de survie des états présents sont calculées par les opérations consistant à :

- ajouter la valeur métrique précédente provenant du premier registre et une valeur métrique de branche du présent état calculée par le calculateur pour fournir une première valeur ajoutée ;
- ajouter la valeur métrique précédente provenant du second registre et une valeur métrique de branche de l'état suivant calculée par le calculateur pour fournir une seconde valeur ajoutée ; et
- comparer les première et seconde valeurs ajoutées et calculer en conséquence une valeur métrique de survie.

10. Egaliseur de Viterbi comprenant :

- une partie de pré-traitement de Viterbi pour estimer une réponse impulsionnelle des canaux à partir de données reçues et pour filtrer les données à l'aide de la réponse d'impulsion à l'aide d'un processeur de signaux numériques ; et
- un appareil de traitement par algorithme de Viterbi, comprenant un appareil d'addition-comparaison-sélection haute vitesse tel que défini à l'une quelconque des revendications 1 à 4, pour effectuer un algorithme de Viterbi pour l'égalisation des données filtrées à l'aide de la réponse impulsionnelle des canaux estimée fournie par la partie de pré-traitement de Viterbi.

11. Egaliseur selon la revendication 10, dans lequel la partie de pré-traitement multiplie une inversion de la réponse d'impédance des canaux estimée par les données reçues, et décale dans le temps le résultat multiplié.

EP 0 944 173 B1

RECEIVED DATA → BMC (1b) → ACS (2b) → PATH MEMORY (4b) → TBC (5b) → DECODED DATA

METRIC MEMORY (3b)

FIG. 1

FIG. 2

RECEIVED DATA → **EDC** (1a) → **ACS** (2a) → **PATH MEMORY** (4a) → **TBC** (5a) → DECODED DATA

**METRIC MEMORY** (3a)

# FIG. 3A

FIG. 3B

EP 0 944 173 B1

FIG. 4

EP 0 944 173 B1

FIG. 5

FIG. 6